Europäisches Patentamt

European Patent Office

Office européen des brevets

(19)

(11) Publication number: 0 231 112
A2

(12) **EUROPEAN PATENT APPLICATION**

(21) Application number: 87300626.6

(22) Date of filing: 26.01.87

(51) Int. Cl.³: **G 03 C 1/76**
**G 03 F 7/02, G 03 F 3/10**

(30) Priority: 28.01.86 US 823384
18.06.86 US 877093

(43) Date of publication of application:
05.08.87 Bulletin 87/32

(84) Designated Contracting States:
BE DE FR GB IT NL

(71) Applicant: MINNESOTA MINING AND
MANUFACTURING COMPANY
3M Center, P.O. Box 33427
St. Paul, Minnesota 55133-3427(US)

(72) Inventor: Cook, Jack E. c/o Minnesota Mining and
Manufacturing Company 2501 Hudson Road
St. Paul Minnesota 55133-3427(US)

(72) Inventor: DeMaster, Robert D. c/o Minnesota Mining and
Manufacturing Company 2501 Hudson Road
St. Paul Minnesota 55133-3427(US)

(72) Inventor: Kang, Soonkun c/o Minnesota Mining and
Manufacturing Company 2501 Hudson Road
St. Paul Minnesota 55133-3427(US)

(72) Inventor: Shor, Steven M. c/o Minnesota Mining and
Manufacturing Company 2501 Hudson Road
St. Paul Minnesota 55133-3427(US)

(74) Representative: Bowman, Paul Alan et al,
LLOYD WISE, TREGEAR & CO. Norman House 105-109
Strand
London WC2R OAE(GB)

(54) Imageable material and process.

(57) Modification of surface topography and/or application of
optical modification layers to the surface or exposed support
areas of photosensitive media to increase transmission of
white light through the surface by at least 2 percent. The
modification allows for normal imaging and processing and
provides improved visual and sensitometric properties to the
media.

EP 0 231 112 A2

IMAGEABLE MATERIAL AND PROCESS

BACKGROUND OF THE INVENTION

1. Field of the Invention

The present invention relates to imageable materials and images having surfaces which are highly transmissive of visible and/or actinic radiation. The present invention further relates to images on transparent substrates, particularly color separation transparency images and more particularly to color overlay separation transparency proofing images. The use of highly transmissive film substrates improves the optical quality of the image, both on individual sheets as well as in the overlay.

2. Background of the Art

It is desirable to have light-transmissive surfaces on radiation-sensitive elements and image-bearing elements. Reflective surfaces reduce the sensitivity of photosensitive elements and can reduce the visual quality of the final image. Reflectivity, particularly on the backside of transparent substrates, can cause halation during imaging and apparent darkness of the final image. One means that has been used to correct part of the problem is to coat the developed film or print with an antireflective coating as taught in U.S. Patent 3,617,354. The coating is applied after processing to avoid interference with processing solutions.

Overlay proofs are extremely useful to the printing industry. They provide a means for predicting the quality of the printed image which is to follow. Overlay proofs are made by sequentially and separately forming single color proof images on a transparent substrate of the cyan, magenta, yellow and black separations and laying them one over another in register. This provides a proof of the final printed image.

Surlay proofs are similarly useful and may be made on a transparent receptor sheet. In surlay proofing, separate individual color proofing images of the cyan, magenta, yellow and black separations are made on a carrier sheet and transferred one at a time in register onto a receptor sheet.

The use of individual color proof images in forming the composite has distinct advantages over surlay proofs. The proof of each color can be separately viewed, and corrections of single colors can be readily made. The proofs can also be evaluated in pairs to judge combinations of two colors or in threes to compare three color proofs. On the other hand, the separation of the image into individual colors on separate sheets produces an adverse effect on the total color rendition. Individual color proofs lose some color fidelity because of spectral and diffuse reflection off the surface of the proof. The overlay sheets produce a shift in apparent color rendition in which the topmost colors are relatively dominant and the lower colors relatively weakened. This latter effect is a compounding of the former effect and is apparently due in part to the multiple resin and air interfaces between the sheets which exhibit large differences in refractive indices.

Some printers have temporarily laminated overlay proof sheets with non-adhesive liquids such as mineral oil to overcome the problem. This is a least desired procedure because it is messy and does not allow for general handling of the proof.

U.S. Patent 4,366,223 discloses a process for adhesively laminating proofs in register to remove air interfaces between the overlay proofs. This prevents further individual analysis of single color proofs and removes one of the advantages of color overlay proof systems.

## SUMMARY OF THE INVENTION

The present invention relates to a photosensitive

imaging system on a transparent base wherein the base or the photosensitive imaging element displays significantly increased transparency to white light because of a modification of a surface of the base or the element. The invention particularly relates to photographic, photohardenable, photosolubilizable, and phototackifiable polymeric imaging systems on a transparent substrate having at least 93% transparency, especially those useful in color prepress proofing systems, and to other imaging systems of a photosensitive layer on a substrate.

### DETAILED DESCRIPTION OF THE INVENTION

The present invention relates to a photosensitive imaging system or image on substrates and especially to such systems or images on a transparent substrate. The photosensitive system may comprise any photosensitive imaging system known in the art, including but not limited to silver halide photographic emulsions (e.g., black-and-white negatives, black-and-white slides, color negatives, color slides), dry silver photothermographic imaging systems wherein a transparent support is used for the original image (e.g., U.S. Patents 3,457,075 and 4,460,681) and where dye images are transferred onto a transparent receptor sheet (e.g., U.S. Patents 4,262,071 and 3,649,332), diffusion or sublimation transfer dye imaging systems (e.g., U.S. Patents 4,587,198 and 3,860,388), dye bleach systems (e.g., U.S. Patents 4,548,896 and 4,373,020), leuco dye oxidation systems (e.g., U.S. Patents 4,460,677 and 4,370,401), resistive or dye layer wash-off systems both positive and negative-acting (e.g., U.S. Patents 4,504,572, 4,427,757, 4,369,245, 4,571,373 and 3,671,236), phototackifiable compositions (e.g., U.S. Patent 3,649,268), and other available systems for the generation of color images (e.g., U.S. Patent 4,450,227 and 4,447,521). Any of the varied image forming technologies may be used in the practice of the present invention. It is more preferred to use color image forming technologies in the practice of the present invention and most preferred to use the photohardenable, photosolubilizable and phototackifiable polymeric color imaging systems generally used in the color prepress proofing art. These systems are represented by the following patents: 3,671,236, 3,136,637 and 3,649,268, respectively.

Photohardenable, photosolubilizable and phototackifiable systems are well known in the art as are photographic imaging systems. Photohardenable compositions are layers which contain materials capable of being rendered less soluble in a developing media (such as water, aqueous alkaline solutions, aqueous/organic solutions, and organic solutions) by exposure to actinic radiation. Typical photohardenable compositions will contain one or more polymerizable components (e.g., monomers, oligomers, or polymers from functionalities such as acrylics, methacrylics, vinyls, allyls, acrylamide, epoxy resins, and the like), binders (e.g., film forming binder resins, heat softenable binders), oleophilic agents, photosensitizers (e.g., diazonium salts, diazonium resins, iodonium salts, sulfonium salts, s-triazines, biimidazoles, etc.), spectral sensitizing dyes, surfactants, coating aids, matting agents, dyes, pigments, etc. These layers become less soluble where irradiated so that unexposed areas are more readily removed by developer solutions.

Photosolubilizable compositions become more soluble in areas exposed to radiation. This process can be effected by the addition of a light sensitive insoluble species to a soluble resin. The insoluble species becoming more soluble when exposed to actinic radiation, thus rendering the composition more soluble in light struck areas. Resins which are broken down by residues generated from light sensitive agents may also be used in this process. Such techniques are shown in U.S. Patents 3,782,939, 4,260,673 and 4,247,616.

Phototackifiable compositions rely upon changes in the surface tackiness of layers, the changes being affected by actinic radiation. Areas may be rendered either more tacky or less tacky by the exposure to radiation. The surface is then powdered with a toner which differentially adheres in exposed and non-exposed areas. Such processes are shown in U.S. Patent 3,649,268.

Any of these systems, when used in combination with the substrates of the present invention, show improved tonal qualities in the image and provide a more faithful reproduction of color images.

When an opaque substrate is used in the practice of the present invention, the surface modification to improve transparency must be present on the exposed surface (light-sensitive surface) of the photosensitive layer or layers. When a transparent substrate is used, the surface modification must be present on at least one exterior surface of the photosensitive element or a surface that is permanently exposed to the atmosphere during the development process. For example, on photographic paper, the surface modification must be present on the exterior surface of the light-sensitive layer. There could of course be no benefit to having any optical modification on the backside of the paper. On negative film or slide film, the surface of the photosensitive side and/or the support backside can be modified to improve optical properties. In a two-side coated photographic film such as medical X-ray film, both photosensitive sides of the film can be coated. In transparent BAS resist imaging systems, the backside of the support, the surface of the resist layer, and the surface of the support can all benefit from surface modifications according to the teachings of the present invention. With resist imaging materials, coating of both sides of the support is in fact very desirable. As development places portions of the support which were underneath the photosensitive media in contact with air, and those portions are supposed to be transparent, modifying that surface to increase its transparency is highly desirable.

Certain considerations must be made in determining the suitability of various types and locations of surface modifications. Embossment of light-transmission increasing topographies onto surfaces which are known to be pressure-sensitive or onto elements whose image quality is adversely affected by pressure should be avoided. The use of coatings to modify optical properties must be carefully chosen where liquid developing solutions are needed. A coating should not be so coherent that a resist layer cannot be developed from under it and should not be so readily removed that no optical properties remain after resist development. When liquid developers and processing solutions must penetrate into and be removed out of layers, the optical transmission coatings must be readily penetrable by the solutions. The utility of the various surface modifying procedures can be easily determined and properly selected.

The substrates of the present invention generally comprise transparent film in which the transparency of the unmodified film is increased by at least 2% in a 50 nm range between 420 and 750 nm as measured by a transmission spectrophotometer. This improvement may be made by microembossing of the surface, microtexturizing of the surface or most preferably by the application of transparentizing coatings as taught in the present invention. Preferably the transparency of the sheet is increased by at least 5% and most preferably by at least 7% over a 50 nm range between 420 and 750 nm.

The preferred substrate of the present invention is a transparent substrate having a diffuse optical transmission of at least 93% to white light as measured by a transmission spectrophotometer. When the term "transmission to white light" is used in the practice of the present invention, it is meant that the average transmission between 420 and 750 nm is being measured. Thus, 95% transmission to

white light is provided by a film transmitting only 90% of radiation between 420 and 500 nm, but which transmits 97% of radiation between 500 and 750 nm. The term percentage transmission to radiation within a 50 nm range between 420 and 750 indicates that transmission within at least one 50 nm range within the broad range is being measured and performs at that percentage level. Transparent substrates provided for photographic film, color prepress proofing overlays and other imaging materials have transmission properties in the range of 82-90%. No commercially available film used in imaging processes is known to have the transmission properties required in the practice of the present invention. It is preferred that the substrates of the present invention have transmission properties of at least 96%, more preferably at least 97%, still more preferably at least 98%, and most preferably at least 99%.

The most convenient way of providing transparent film with these properties is to take conventional transparent film (i.e., film with transmissivity of less than 95%) and modify its surface topography so that the effective index of refraction of the surface of the film or a coating on the film is lower than that of the film. The index of refraction of the surface is made to be closer to the index of refraction of air than the original index of refraction of the bulk composition of the film. Both surfaces of the film are preferably treated in this manner. The index of refraction at the surface is preferably made at least 5% closer to the index of refraction of air than the original index of refraction of the composition of the film. A preferred index of refraction of the film surface is one exactly intermediate that of the bulk film composition and air.

Modification of the topography (morphology) of the film surface can be accomplished in a number of different ways. The surface may be sputtered (i.e., sputter-etched or sputter-deposition), micro-etched, microdeposited, microembossed, or coated to effect the surface changes. The modifications of the surface structure must create a morphology in which the dominant average dimensions are within a definite size range. The surface structure must have features (i.e., bumps, depressions, peaks, valleys, gaps, points, etc.) having spatial dimensions and frequencies between 25 and 250 nm. Smaller dimensions tend to allow transmission of disproportionate amounts of blue light, thereby adding a blue hue to the image. Larger dimensions tend to reflect too much blue light and add a yellow hue to the image. It is preferred that the frequency and dimensions of the topographic features be between 40 and 200 nm. The preferred index of refraction of the film surface ($n_s$) is determined by $n_s = n_a(n_b)$ wherein $n_a$ and $n_b$ respectively represent the indices of refraction for air and the bulk film composition. To best utilize the present invention with specific colors in the imaging material, the frequency and dimensions of the surface features should provide an optical wavelength that is approximately 1/4 of the wavelength of the maximum wavelength of the color in the image or the sensitivity of the sheet. For a black image, the features and frequency should approximate a central wavelength such as 50 to 150 nm. The optical wavelength is equal to the refractive index multiplied by the physical thickness of the layer or feature.

Surface treatments of films conventionally used in photographic procedures, such as matting agents, anti-slip agents and diffuse transmitting layers, do not cause changes in the topography on the same order as required to effect practice of the present invention. Matting and anti-slip agents are consistently larger than 1000 nm, for example, and do not have the frequency of even those dimensions within the feature frequency desired in the practice of the present invention.

The terms frequency and dimension are used to denote different axes in the surface topography. Frequency

refers to a horizontal axis or the planar axes of the surface. The frequency of features is therefore the number of features in a linear direction on the surface of the layer. The term dimension refers to the height or depth of a feature with respect to either the unmodified surface of the film, the average height of the surface of the film, or the lowest unmodified plane on the film surface, whichever reference point is most conveniently used. Both the frequency and dimension of the features on the surface are preferably within the size range previously described.

The most preferred transparent substrate of the present invention comprises a polymeric film having at least one (and preferably both) surfaces coated with a network of particles. By selecting the size of the particles within the range of 0.5 to 50 nm, the layer with a thickness between about 25 to 250 nm will have the required transmissivity properties desired in the practice of the present invention. The particles may be embedded in or fused to the surface so as to essentially completely cover the surface with particles having average dimensions of 0.5 to 50 nm, they may be bound as a layer to the surface with a light binder matrix (e.g., 1-20% by weight of polymer binder to weight of particulates), or more preferably be present as a gelled network of particles. Most preferably the coating is a continuous gelled network of inorganic oxide particles having average particle diameters of 0.5 to 50 nm.

The substrate of the invention most preferably bears a coating comprising a continuous gelled network of inorganic metal oxide particles. The particles preferably have an average primary particle size of less than about 500 or 200 Angstroms. As used herein, the term "continuous" refers to covering the surface of the substrate with virtually no discontinuities or gaps in the areas where the gelled network is applied. However, the layer may be porous, without significant straight-line pores or gaps in the layer. The term "gelled network" refers to an aggregation of colloidal particles linked together to form a porous three-dimensional network. The term "porous" refers to the presence of voids between the inorganic metal oxide particles created by the packing of the metal oxide particles. The term "primary particle size" refers to the average size of unagglomerated single particles of inorganic metal oxide. The term "particle" includes spherical, non-spherical, and fibrillar particulate arrangements.

The articles of the invention most preferably comprise an image or imaging media on a substrate which is transparent to visible light having at least one polymeric surface, and have formed thereon a coating in the form of a continuous gelled network of inorganic oxide particles, preferably metal oxide or silica particles. When the coating is applied to transparent substrates to achieve increased light transmissivity, the coated article preferably exhibits a total average increase in transmissivity of normal incident light of at least two percent and up to as much as ten percent or more, when compared to an uncoated substrate, depending on the substrate coated, over a range of wavelengths extending at least between 400 to 900 nm. An increase in light transmission of two percent or more is generally visually apparent and is sufficient to produce a measurable increase in energy transmissivity when the coated substrate is used in applications such as windows and solar collector cover plates. An increase in transmissivity is also present at wavelengths into the infrared portion of the spectrum.

Also according to the teachings of the present invention any conventional photographic element can be rendered highly light transmissive by application to at least one surface of the element a solution or suspension containing colloidal inorganic oxide particles, the particles having an average primary particle size of less than about 20 nm (200 A), preferably 1 to 20 nm, more preferably 2 to 10 nm, and drying the coating at a temperature less than that which degrades the element, e.g., less than 100°C, generally 15 to 70°C, thereby providing the coated substrate with antireflection properties. The coating solution preferably contains about 0.2 to 15 weight percent colloidal inorganic oxide particles.

An article of the invention preferably comprises a silver halide photographic element which may be transparent, translucent, or opaque to visible light and is made of organic and inorganic materials, and has on at least one surface thereof a coating in the form of a continuous gelled network of inorganic oxide particles. When the coating is applied to transparent substrates to achieve increased light transmissivity, the coated article preferably exhibits a total average increase in transmissivity of normal incident light of at least one percent, and preferably at least two percent and up to as much as ten percent or more, when compared to an uncoated element, depending on the element coated, over a range of wavelengths extending at least between 350 to 1000 nm. An increase in transmissivity is also present at wavelengths farther into the infrared portion of the spectrum.

The gelled network is a porous coating having voids between the inorganic oxide particles. If the porosity is too small, the transmissivity may be reduced. If the porosity is to large, the coating is weakened and may have reduced adhesion to the substrate. Generally, the colloidal solution from which the gelled network is obtained is capable of providing porosity of about 25 to 70 volume percent, preferably about 30 to 60 volume percent when dried. The porosity can be determined by drying a sufficient amount of the colloidal solution to provide a dried product sample of about 50 to 100 mg and analyzing the sample using a "Quantasorb" surface area analyzer available from Quantachrome Corp., Syosett, NY.

The voids of the porous coating provide a multiplicity of subwavelength interstices between the inorganic particles where the index of refraction abruptly changes from that of air to that of the coating material. These subwavelength interstices, which are present throughout the coating layer, provide a coating which may have a calculated index of refraction (RI) of from about 1.15 to 1.40, preferably 1.20 to 1.30 depending on the porosity of the coating. When the porosity of the coating is high, e.g., about 70 volume percent or more, lower values for the RI are obtained. When the porosity of the coating is low, e.g., 25 volume percent or less, higher values for the RI are obtained.

The average primary particle size of the colloidal inorganic oxide particles is preferably less than about 50 nm. The average primary particle size of the colloidal inorganic metal oxide particles is more preferably less than about 25 nm. When the average particle size becomes too large, the resulting dried coating surface is less efficient at improving the transmission properties of the coating.

The average thickness of the dried coating is preferably from about 25 to 250 nm, more preferably 40 to 200 nm and most preferably between 50 and 175 nm. When the coating thickness is too great, the coating has reduced adhesion and flexibility and may readily flake off or form powder under mechanical stress.

Articles such as transparent sheet or film materials may be coated on a single side or on both sides to increase light transmissivity, the greatest increase being achieved by coating both sides.

Such coatings also provide good antistatic properties. Additionally, Newton rings caused by one clear film contacting another are eliminated with the use of the surfaces of the present invention as a contacting surface between films.

The process of coating the layer of the present invention comprises coating a substrate, e.g., the base support layer or photosensitive element or photosensitive

layer, with a solution of colloidal inorganic metal oxide particles, the solution preferably containing 0.2 to 15 weight percent of the particles, the particles preferably having an average primary particle size less than about 500 or 200 Angstroms, more preferably less than about 70 Å, and drying the coating at a temperature less than that which degrades the substrate, preferably less than about 200°C, more preferably in the range of room temperature (20°C) to 120°C. The coating provides the substrate with an average increase in transmissivity of at least two percent over wavelengths of 400 to 800 nm.

Coating may be carried out by standard coating techniques such as bar coating, roll coating, curtain coating, slide coating, rotogravure coating, spraying and dipping. The surface or substrate may be treated prior to coating to obtain a uniform coating using techniques such as corona discharge, flame treatment, and electron beam. Substrates for this invention may be primed and/or subbed with gelatin coatings.

The colloidal inorganic oxide solution, e.g., a hydrosol or organosol, is applied to the substrate of the article to be coated and dried at a moderately low temperature, generally less than about 200°C, preferably 60-120°C, to remove the water or organic liquid medium. The coating may also be dried at room temperature, provided the drying time is sufficient to permit the coating to dry completely. The drying temperature should be less than at which the substrate degrades. The resulting coating is hygroscopic in that it is capable of absorbing and/or rehydrating water, for example, in an amount of up to about 15 to 20 weight percent, depending on ambient temperature and humidity conditions.

The colloidal inorganic oxide solution utilized in the present invention comprises finely divided solid inorganic metal oxide particles in a liquid. The term "solution" as used herein includes dispersions or suspensions of finely divided particles of ultramicroscopic size in a liquid medium. The solutions used in the practice of this invention are clear to milky in appearance.

Inorganic metal oxides particularly suitable for use in the present invention include boehmite (alpha-$Al_2O_3 \cdot H_2O$), tin oxide ($SnO_2$), antimony oxide ($Sb_2O_5$), zirconium oxide ($ZrO_2$), silica, and alumina-coated silica as well as other inorganic metal oxides of Groups III and IV of the Periodic Table and mixtures thereof. The selection of the inorganic metal oxide is dependent upon the ultimate balance of properties desired.

Examples of commercially available inorganic metal oxides include "Dispural" and "Pural" boehmite available from Condea Petrochemie GmbH, "Catapal" SB, boehmite available from Vista Chemical Co., and "Nalco" ISJ-614, alumina sol, "Nalco" ISJ-611, antimony oxide sol, "Nalco" 2326, silica sol, and "Nalco" ISJ-613, alumina-coated silica sol, available from Nalco Chemical Company.

The colloidal coating solution preferably contains about 0.2 to 15 weight percent, preferably about 0.5 to 10 weight percent, colloidal inorganic metal oxide particles. At particle concentrations about 15 weight percent, the resulting coating may have reduced uniformity in thickness and exhibit reduced adhesion to the substrate surface. Difficulties in obtaining a sufficiently thin coating to achieve increased light transmissivity and reduced reflection may also be encountered at concentrations above about 15 weight percent. At concentrations below 0.1 weight percent, process inefficiencies result due to the large amount of liquid which must be removed and transmissivity properties may be reduced.

The thickness of the applied wet coating solution is dependent on the concentration of inorganic metal oxide particles in the coating solution and the desired thickness of the dried coating. The thickness of the wet coating solution is preferably such that the resulting dried coating thickness is from about 10 to 500 nm, preferably 25 to 250 nm thick, more preferably about 40 to 200 nm thick.

The coating solution may also optionally contain a surfactant to improve wettability of the solution on the substrate, but inclusion of an excessive amount of surfactant may reduce the adhesion of the coating to the substrate. Examples of suitable surfactants include "Tergitol" TMN-6 (Union Carbide Corp.) and "Triton" X-100 (Rohm and Haas Co.) and Triton X-200. Generally the surfactant can be used in amounts of up to about 0.5 weight percent of the solution.

The coating solution may optionally contain a polymeric binder to aid in adhering the coating to the substrate. Useful polymeric binders include polyvinyl alcohol, polyvinyl acetate, polyesters, polyamides, polyvinyl pyrrolidone, copolyesters, copolymers of acrylic acid and/or methacrylic acid, and copolymers of styrene. The coating solution can contain up to about 20 weight percent of the polymeric binder based on the weight of the inorganic metal oxide particles. Useful amounts of polymeric binder are generally in the range of 1 to 15 weight percent. These binders can reduce some of the beneficial properties (e.g., antistatic properties) of the coatings so are not most preferred.

As mentioned above, in a preferred embodiment for any conventional silver halide-containing radiation-sensitive elements, these elements can be provided with at least one surface coating of inorganic oxide particles. Typically, a silver halide-containing radiation-sensitive element comprises a polymeric base, a gelatin silver halide emulsion, and frequently an antihalation layer, and abrasion-resistant topcoat layers. The gelled network of inorganic oxide particles on at least one surface conveys high light transmission properties to the element.

The base layer of the silver-halide photographic element may be rough or smooth, transparent or opaque, flexible or rigid, continuous or discontinuous, and porous or non-porous. It may be of natural or synthetic polymeric resin (thermoplastic or thermoset), ceramic, glass, metal, paper fabric, and the like. For most commercial purposes the base is preferably a polymeric resin such as polyester [e.g., poly(ethyleneterephthalate)], cellulose ester, polycarbonate, polyvinyl resin [(e.g., poly(vinyl chloride), poly(vinylidene chloride), poly(vinylbutyral), poly(vinyl-formal)], polyamide, polyimide, polyacrylate (e.g., copolymers and homopolymers of acrylic acid, methacrylic acid, n-butyl acrylate, acrylic anhydride and the like), polyolefin, and the like. The polymer may be transparent, translucent or opaque. It may contain fillers such as carbon black, titania, zinc oxide, dyes, pigments, and of course, those materials generally used in the formation of films such as coating aids, lubricants, antioxidants, ultraviolet radiation absorbers, surfactants, catalysts and the like.

Even when the substrate is opaque, the element of the present invention has improved transmission through the imageable layers which provides increased speed and higher resolution. In the processed article, there is provided lower gloss, higher contrast and a sharper image.

The type of gelatin silver halide emulsion is not critical. Emulsions can be simple or mixed emulsions (as to halide composition and crystal size) of silver chloride, silver bromide and silver iodide, both of fine and coarse grain, and can be prepared by various methods as described in Research Disclosure 18431, August 1979, paragraphs 1A and 1B. The emulsions can be chemically sensitized during or before chemical curing by adding sensitizing agents as described in Research Disclosure 18431, August 1979, paragraph 1C. The emulsions can contain stabilizing, anti-fog, development modification and anti-staining agents, agents which increase covering power, hardeners, plasticizers and anti-creasing agents as described in Research Disclosure 13431, August 1979, paragraphs II and II A-X. The emulsions can be sensitized spectrally, for example, in the wavelength region of the light emitted by the reinforcing screens in the case of elements used for radiography, as described in Research Disclosure 18431, August 1979, paragraphs IX and X. In addition, besides gelatin and its partial or total substituent, the protective layer can comprise dyes, plasticizers, antistatic agents and development accelerators as described in Research Disclosure 18431, August 1979, paragraph IV. The emulsion is preferably spread over a polyester support as described in Research Disclosure 18431, August 1979, paragraph XII, but other supports, for example, cellulose derivatives (cellulose nitrate, cellulose triacetate, cellulose propionate, cellulose acetate propionate, etc.), poly(vinyl chloride), polystyrene, polycarbonates, glass, paper, etc., can be used.

The photographic element according to the present invention can in addition comprise antistatic agents and layers as described in Research Disclosure 18431, August 1979, paragraph III. As is known in the art, various antihalation agents can be utilized in a separate layer or in any of the layers of the element, including one or more topcoats as is taught, for example, in Research Disclosure 17643, paragraph VIII, December 1978. Topcoats can be useful to provide the element with abrasion resistance. Such layers are disclosed, for example, in Research Disclosure 18431, paragraph IV, August 1979.

In accordance with the present invention, in a preferred embodiment a photographic imaged article can be provided by a process involving the steps:

a) providing a silver halide radiation-sensitive imageable element having on at least one surface a coating of inorganic oxide particles having an average primary particle size of less than 20 nm,

b) imagewise exposing the element to radiation in the range of 350 to 1000 nm,

c) subjecting the radiation-exposed element to developer and wash solutions (see Research Disclosure 17643, December 1978, for typical solutions),

d) and drying the developed element in air or in an oven (at a temperature from 20 to 60°C) to provide a photographic imaged article.

The present invention finds utility in emulsion to emulsion contact exposure, base to emulsion, and emulsion to base contact exposure, and contact exposures where several layers of imaged films are overlayed to make a composite image by exposing through the overlays to an unexposed element of the invention. In the latter case the increased transparency of all the overlays is additive and the scatter due to reflection is minimized such that a higher level of quality is possible than when using overlays without the applied coating of this invention. If the overlays are elements of the invention, then a cumulative increased light transmission of 10 to 15 percent or more for four overlays can be achieved.

In the use of multiple color overlays, the thickness or topography of the transparentizing surface of the substrate may be different from sheet to sheet. Each sheet may be chosen with a transparentizing surface best suited for the individual color within that sheet in order to improve each individual sheet as well as to improve the overall performance of the sheet.

## EXAMPLES

Example 1

A boehmite sol was prepared in a Waring blender at room temperature by mixing for one minute 176 g boehmite ("Dispural", available from Condea Petrochemie GmbH, West Germany) and 400 ml distilled water acidified with 11 g concentrated nitric acid (70%). 225 g of the boehmite sol were diluted to 15% solids solution with water and centrifuged for thirty minutes at 2700 rpm to remove a small

amount of undispersed particles. This sol was further diluted with water to make coating solutions containing 2.5, 5.0, 7.5, and 10.0 percent solids.

Each solution was coated onto one surface of a 0.10 mm thick corona-treated biaxially oriented polyethylene terephthalate film with an ultraviolet absorbent added. A thin bead of the coating solution was applied along a 15.0 cm side of a 25.0 cm x 25.5 cm piece of film secured to a flat surface. A No. 4 Meyer bar (No. 4 wire wound on a 0.63 diameter, 40 cm long rod, manufactured by E. D. Specialties) was drawn through the solution bead down the length of the film over a 4 sec period. The coated film was dried at 100°C for 3 min.

The total solar transmission (wavelength between 300 to 2200 nm) of an uncoated film and films coated with solutions containing 5, 7.5 and 10 percent boehmite solids was measured using a Beckman UV-VS 524 Spectrophotometer. The results, in Table 1, show the increase in total solar transmission provided by the coatings with the greatest increase in total solar transmission being achieved by using a coating solution containing 5% solids.

## Table 1

| Coating Solution Solids Content (%) | Total Solar Transmission (%) |
|---|---|
| Uncoated | 87.9 |
| 5 | 93.5 |
| 7.5 | 92.1 |
| 10 | 92.3 |

To evaluate antistatic properties, the surface resistivity of the film coated with the solution containing 5% solids was determined using ASTM Test Method D-257 at relative humidities (R.H.) of 0, 20, and 50 percent. The results, in Table 2, show the reduction of surface resistivity to be greater at increasing relative humidity.

Table 2

| R.H. (%) | Surface Resistivity (ohm/square) |
|----------|----------------------------------|
| 0 | $1.9 \times 10^{11}$ |
| 20 | $2.1 \times 10^{9}$ |
| 50 | $5.3 \times 10^{8}$ |

To evaluate antistatic properties as a function of solution concentration, surface resistivities of an uncoated film and films coated with the solutions containing 5, 7.5, 10, and 15 percent solids content were determined at 50% relative humidity. The results, in Table 3, show the reduction in surface resistivity provided by coatings of the invention increases as the solids concentration of the coating solution increases, indicating a reduction in static propensity of the coated film.

Table 3

| Coating Solution Solids Content (%) | Surface Resistivity (ohm/square) |
|-------------------------------------|----------------------------------|
| Uncoated | $2.7 \times 10^{15}$ |
| 5 | $5.7 \times 10^{9}$ |
| 7.5 | $2.1 \times 10^{9}$ |
| 10 | $1.2 \times 10^{9}$ |
| 15 | $9.2 \times 10^{8}$ |

Example 2

Corona-treated 0.05 mm thick polypropylene films were coated with a boehmite solution containing 2.5% solids prepared as in Example 1 using a No. 4 Meyer bar and dried at 100°C for 1.5 min. Films were coated on one side (Sample A) and on both sides (Sample B). The coated films together with an uncoated comparative film were tested for light transmission using a Beckman UV-VIS 524 Spectrophotometer. The results, in Table 4, demonstrate the increase in light transmission provided by the coatings, with greater average light transmission for the film having the coating on both sides.

### Table 4

| Sample | Light Transmission (%) at Wavelength (nm) | | | | | | |
|---|---|---|---|---|---|---|---|
| | 300 | 400 | 500 | 600 | 700 | 800 | 900 |
| Uncoated | 84.2 | 88.5 | 89.8 | 90.4 | 90.4 | 91.4 | 91.2 |
| A | 86.4 | 90.9 | 92.0 | 92.2 | 92.4 | 92.7 | 92.4 |
| B | 85.8 | 90.4 | 93.0 | 94.4 | 95.0 | 95.3 | 92.8 |

### Example 3

Corona-treated 0.05 mm thick polyimide films were coated as in Example 2. The coated films, Sample C (one side coated) and Sample D (two sides coated) and an uncoated comparative film were tested for light transmission. The results, in Table 5, demonstrate the increase in light transmission provided by the coatings, with greater average light transmission for the film having the coating on both sides.

### Table 5

| Sample | Light Transmission (%) at Wavelength (nm) | | | | |
|---|---|---|---|---|---|
| | 500 | 600 | 700 | 800 | 900 |
| Uncoated | 25 | 71 | 81 | 85 | 86 |
| C | 25 | 76 | 87 | 91 | 91.5 |
| D | 22.5 | 82.6 | 93.3 | 96.6 | 96.0 |

### Example 4

A tin oxide sol was prepared by diluting an aqueous tin oxide sol containing 19.23 percent solids concentration tin oxide particles having an average primary particle size of 40 A and having a viscosity of 4.56 cps and pH of 10.0, with water to yield a sol containing 2.5% tin oxide solids. The solution was coated on 0.05 mm thick corona-treated polyethylene terephthalate films using the bar coating method of Example 1. Films were coated on one side (Sample E) and both sides (Sample F). The coated films and an uncoated comparative film were tested for light transmission. The results, in Table 6, show the increase in light transmission provided by the coatings, with greater increase in light transmission for the film having the coating on both sides.

Table 6

| Sample | Light Transmission (%) at Wavelength (nm) | | | | | |
|---|---|---|---|---|---|---|
| | 400 | 500 | 600 | 700 | 800 | 900 |
| Uncoated | 82.0 | 85.0 | 86.9 | 87.8 | 89.0 | 88.0 |
| E | 84.5 | 89.4 | 91.2 | 91.8 | 92.2 | 91.0 |
| F | 93.2 | 95.8 | 95.2 | 94.9 | 94.5 | 93.0 |

Example 5

An antimony oxide sol coating solution was prepared by mixing together 10 g "Nalco" ISJ-611 antimony pentaoxide sol (Nalco Chemical Co.), 14 g water, and 0.025 g "Triton" X-100 nonionic surfactant. The solution was coated on 0.1 mm thick polyethylene terephthalate films using a Photo-Resist Spinner (Model 1-EC 101-R485) coater available from Headway Research, Inc. at speeds of 1000 rpm (Sample G) and 2000 rpm (Sample H). The coated films were dried for 2 minutes at 95°C. The coated films and an uncoated film were tested for light transmission. The results, in Table 7, show the increase in light transmission provided by the coatings, with the coating solution spun at 1000 rpm providing a greater increase in light transmission at higher wavelengths (600 to 900 nm) and the coating solution spun at 2000 rpm providing a greater increase in light transmission at lower wavelengths (400 to 500 nm).

Table 7

| Sample | Light Transmission (%) at Wavelength (nm) | | | | | |
|---|---|---|---|---|---|---|
| | 400 | 500 | 600 | 700 | 800 | 900 |
| Uncoated | 83.5 | 86.7 | 87.7 | 88.2 | 88.8 | 88.0 |
| G | 83.8 | 91.0 | 93.3 | 93.8 | 94.3 | 93.0 |
| H | 89.5 | 92.7 | 92.6 | 92.1 | 91.8 | 91.4 |

Example 6

A boehmite coating solution containing 2.5% boehmite particles was prepared as in Example 1 and coated on 0.05 mm thick polyethylene terephthalate film using the spin coating method of Example 5 at 1000 rpm. The coated film and an uncoated comparative film were tested for light transmission. The reflectance of the uncoated sample was about 12% at 600 nm, while the reflectance of the coated sample was about 4% at 600 nm. The light transmission of the uncoated film was about 88% at 600 nm, while the light transmission of the coated sample was about 96% at 600 nm. This demonstrates the excellent reduction of reflectance and increase in transmission of light provided by the coating.

Example 7

A coating solution was prepared by mixing together 2 g "Nalco" ISJ-613, alumina-coated silica sol available from Nalco Chemical Co., 16.2 g ethanol, and 0.025 g "Tergitol" TMN-6. The solution was coated on 0.10 mm thick clear polyethylene terephthalate film using a spin coater as in Example 5 at 2000 rpm (Sample I) and 3000 rpm (Sample J). The coated films were dried for 2 minutes at 95°C. The coated films and an uncoated film were tested for light transmission. The results, in Table 8, show the increase in light transmission provided by the coating, with the coating solution spun at 2000 rpm providing greater average increase in light transmission than the sample having the coating spun at 3000 rpm.

### Table 8

**Light Transmission (%) at Wavelength (nm)**

| Sample | 400 | 500 | 600 | 700 | 800 | 900 |
|---|---|---|---|---|---|---|
| Uncoated | 83.5 | 86.7 | 87.7 | 88.2 | 88.8 | 88.0 |
| I | 90.6 | 97.1 | 97.5 | 96.7 | 96.3 | 94.3 |
| J | 94.5 | 96.6 | 96.2 | 95.0 | 94.0 | 93.3 |

### Example 8

Coating solutions were prepared by mixing together varying amounts of "Nalco" ISJ-614, alumina sol, "Nalco" ISJ-613, alumina-coated silica sol, and ethanol (EtOH). The amounts used are shown in Table 9. Each solution was coated on a 0.10 mm thick clear polyethylene terephthalate film using a spin coater as in Example 5 at 4000 rpm. The coated films were dried for 2 minutes at 95°C. The coated films and an uncoated film were tested for light transmission. The results, in Table 9, show the excellent increase in light transmission provided by the coatings. At the coating conditions used, the coatings containing greater amounts of the alumina-coated silica particles (Samples M and N) provided a greater increase in light transmission than the coatings containing greater amounts of alumina particles (Samples K and L).

### Table 9

| | Solution Composition | | | Light Transmission (%) at Wavelength (nm) | | | | | |
|---|---|---|---|---|---|---|---|---|---|
| | Nalco ISJ-614 | Nalco ISJ-613 | ETOH | | | | | | |
| Sample | (g) | (g) | (g) | 400 | 500 | 600 | 700 | 800 | 900 |
| Uncoated | 0 | 0 | 0 | 83.5 | 86.7 | 87.7 | 88.2 | 88.8 | 88.0 |
| K | 15 | 0 | 70 | 85.0 | 91.0 | 92.5 | 93.0 | 93.5 | 92.5 |
| L | 10 | 5 | 70 | 86.0 | 92.0 | 93.5 | 94.0 | 93.5 | 93.0 |
| M | 5 | 10 | 70 | 87.0 | 94.0 | 96.0 | 96.0 | 96.0 | 94.5 |
| N | 0 | 15 | 70 | 91.5 | 96.5 | 97.0 | 96.0 | 95.5 | 94.5 |

Example 9

A boehmite coating solution containing 2.2% boehmite particles was prepared as in Example 1. To this solution was added 0.1% "MOVIOL" 4-98, polyvinyl alcohol polymeric binder available from American Hoechst, Inc. The solution was coated on 0.05 mm thick poly(ethylene terephthalate) film using a No. 4 Meyer bar. The solution was applied to one side of the film and the coated film was dried at 125°C for 1.5 minutes. The solution was then applied to the other side of the film and the coated film was again dried for 1.5 minutes. The coating was resistant to damage when subjected to moderate to heavy rubbing by hand. The coated film and an uncoated film of the same material were tested for light transmission. The results, in Table 10, show the increase in light transmission provided by the coating containing boehmite particles with an adhesion promoting binder.

Table 10

| Sample | Light Transmission (%) at Wavelength (nm) | | | | |
|---|---|---|---|---|---|
| | 400 | 500 | 600 | 700 | 800 |
| Uncoated | 83.0 | 85.4 | 86.0 | 86.8 | 87.8 |
| Coated | 91.0 | 95.2 | 94.8 | 94.3 | 94.0 |

Example 10

A coating solution was prepared by diluting an aqueous zirconium oxide sol (20% zirconium oxide solids, primary particle size of about 40 to 50 A, stabilized with 2.6% chloride ion, TAM no. 3000, available from TAM Division of National Lead Co., Inc.) with ethanol to yield a sol containing 2% zirconium oxide solids. The solution was coated on 0.10 mm thick polyethylene terephthalate film using a tissue-wrapped glass rod coating bar. The coated film was dried at 90°C for several minutes. The coated film and an uncoated film were tested for light transmission. The results, in Table 11, demonstrate the excellent increase in light transmission provided by the zirconium oxide coating.

### Table 11

| Sample | Light Transmission (%) at Wavelength (nm) | | | |
|---|---|---|---|---|
| | 500 | 600 | 700 | 800 |
| Uncoated | 84.8 | 88.7 | 89.3 | 89.3 |
| Coated | 89.3 | 94.1 | 94.6 | 94.2 |

Example 11

To a 14.5% dispersion by weight of silica particles (having an average particle size of 5 nm) in water (Nalco[R] 2326) was added an equal weight of distilled water. This dispersion was then further diluted with an equal weight solution of two parts by weight ethanol and one part by weight distilled water. This diluted dispersion was coated on both sides of a poly(ethylene terephthalate) film which had been primed and subbed on both sides with gelatin. The dispersion was first coated on one side with a number 10 wire wound coating bar and dried at room temperature for two hours. Then the other side of the film was similarly coated and dried.

A sensitizer solution was prepared by mixing the following ingredients:

| | | |
|---|---|---|
| Citric Acid | 0.8 grams | |
| Boric Acid | 0.8 grams | |
| Thiourea | 2.4 grams | |
| Photosensitizer | 9.0 grams | (a p-diazodiphenylamine-formaldehyde resin) |
| Deionized water | 950 grams | |
| Triton X-100 surfactant | 1/4 drop | (Octylphenoxy polyethoxy ethanol from Rohm and Haas Company) |

This solution was coated on both pieces, about 22 cm by 38

cm, of this silica-coated film using a No. 3 wire wound coating bar in a dark room under red light. These coatings were dried overnight at room temperature in a dark room. These sensitizer coatings were then coated with a cyan dispersion as described in U.S. Patent 3,136,637 (Example 1). These coatings were dried overnight at room temperature in the dark room.

One of these coated films was exposed through a graphic arts film using a Berkey-Ascor Model 1618-40 vacuum printer with 5000 watt diazo mercury/metal halide light source with an exposure time of 15 seconds. This film was processed through a 3M Brand MR 424 Processor. A yellow color in the background indicated some of the sensitizer was still present. Another exposure for 30 seconds removed most of this yellow color.

Scotch Brand Magic Tape was applied to both transparent and colored areas of the developed image. Removal of the tape from the transparent regions left adhesive on the image. Removal of the tape from the colored areas was clean and much easier than in the clear areas. No adhesive was left on the image in the colored areas. The imaged film had an iridescent appearance in the transparent areas under low angle observation. The effect was not observed in the colored regions.

From these observations, we have demonstrated that a photosensitive coating can be applied to the silica-coated film, imaged and processed away.

Example 12

A dispersion of silica was made by mixing the following:

    20.5 kg Nalco 2326 (a silica dispersion)
    24.8 kg Ethanol (denatured, 5% methanol and 5% propanol)
    35.7 ml Tergitol TMN (trimethylnonyl polyethylene glycol ether)

This dispersion was applied to both sides of a 70 cm wide 100 micron thick poly(ethylene terephthalate) film (both sides primed and subbed) between two rubber squeeze rolls running at 23 meters/minute. After coating, this film passed through a 3 meter draft oven operating at 72°C. After another 3 minutes in a second draft oven operating at room temperature, the film was dry and was rolled up.

The following light transmission values were determined using the Diano spectrophotometer.

### Table 12
#### Light Transmission (%) at Wavelength (nm)

| 400 | 450 | 500 | 550 | 600 | 650 | 700 |
|------|------|------|------|------|------|------|
| 94.3 | 97.4 | 98.8 | 99.2 | 99.3 | 99.3 | 99.2 |

The coated film from above was used for coating the diazo sensitizer and cyan, magenta, yellow and black color layers as taught in U.S. Patent 3,136,637 (Example 1). Sheets, 66 cm by 70 cm, were cut from each of these four rolls. A sheet from each of the 4 colors was used to prepare a 4 color overlay proof using a color separation from a 150 line screen. This proof was compared with a similar one made using Color Key Proofing Films, 3M Company. Optical density data were obtained using a Diano Spectrophotometer, Model Matchscan II (Milton Roy Co., Rochester, NY). Background transmission optical densities were reduced for all four colors. The background of the four overlays together using the substrates of the present invention was very clear as compared to the overlays with presently used commercial substrates which gave a distinct gray tone to the image background.

### Example 13

The coated substrate of Example 12 was used as the substrate in the present example. On that substrate was

first coated the following negative acting imaging composition.

A first dispersion was made by mixing the following ingredients in parts by weight:

1.4 parts pentaerythritol tetraacrylate

0.9 parts urethane oligomer (Preparation IV of U.S. Patent 4,304,923)

0.5 parts polyketone resin (Lawter 1717 B)

0.3 parts acrylated cellusoic resin (35% by weight in n-propyl acetate)

0.3 part triazine initiator

72.6 parts 1,1,2-trichloroethane

19.0 parts of a composition comprising 6.5 parts Naphthanil Red Dark (Heubach), 1.3 parts poly(vinyl formal), 2.0 parts polyketone resin (Lawter 1717B), and 90.2 parts 1,1,2-trichloroethane

5 parts n-propyl alcohol

This dispersion was coated on the silica-coated (polyethylene terephthalate) film described in Example 12 using a No. 8 wire wound coating bar. The coating was dried at 82°C for three minutes.

A solution of Gelvatol 20/90 (polyvinyl alcohol, Monsanto Company) three and one-half weight percent in water, was coated on this magenta layer using a No. 3 wire wound coating bar and dried at 82°C for three minutes.

This film was imaged for 15 seconds in a Berkey-Ascor Model 1618-40 vacuum printer with a 5000 watt photopolymer light source. It was then processed through an alkali developer solution in a Model 527 processor, 3M Company.

These coatings were also made on gelatin primed and subbed poly(ethylene terephthalate) film without the silica antireflection coating and the product imaged in a like manner. Better image quality was obtained using the silica-coated film. The light transmission was compared for the clear area of these two images using the following data from the Diano Spectrophotometer.

### Table 13

| | Light Transmission (%) at Wavelength (nm) | | | | | | |
|---|---|---|---|---|---|---|---|
| Sample | 400 | 450 | 500 | 550 | 600 | 650 | 700 |
| Uncoated | 86.5 | 88.7 | 90.0 | 90.8 | 91.2 | 91.5 | 91.6 |
| Coated | 90.6 | 92.0 | 93.0 | 94.1 | 95.5 | 95.9 | 96.0 |

### Example 14

The silica-coated poly(ethylene terephthalate) film described in Example 12 was used to prepare a tannable, photographic element according to U.S. Patent 4,427,757, Example 1.

After imaging and processing as taught in that example, the light transmission in the transparent regions was measured with the Diano Spectrophotometer, Model Matchscan II. Table 14 shows these results compared with uncoated primed and subbed poly(ethylene terephthalate).

### Table 14

| | Light Transmission (%) and Optical Density at Wavelength (nm) | | | |
|---|---|---|---|---|
| | Coated | | Uncoated | |
| Wavelength | Density | Transmission | Density | Transmission |
| 400 | 0.038 | 91.7 | 0.065 | 86.0 |
| 450 | 0.025 | 94.5 | 0.054 | 88.3 |
| 500 | 0.015 | 96.5 | 0.047 | 89.6 |
| 550 | 0.010 | 97.6 | 0.043 | 90.5 |
| 600 | 0.009 | 98.0 | 0.040 | 91.1 |
| 650 | 0.008 | 98.1 | 0.038 | 91.4 |
| 700 | 0.008 | 98.1 | 0.038 | 91.5 |

### Example 15

This example shows the utility of the transparent substrates of the present invention with photothermographic

compositions, particularly dry silver compositions, and more particularly with color dry silver formulations.

The transparent substrate of Example 12 was used in this example. A first trip master batch was made comprising

| | |
|---|---|
| 50/50 Homogenized mixture of silver behenate and behenic acid | 127.0 g |
| Toluene | 295.0 g |
| Poly(vinyl butyral) | 53.1 g |
| Mercury acetate 0.2 g/100 ml methanol | 3 ml |
| CaBr$_2$ 2.36 g/100 ml MeOh | 12 ml |
| 20% by weight poly(vinyl acetate/chloride) 80/20 copolymer in methylethylketone | 72.0 g |

Fifty grams of this master batch composition was mixed with 0.2 g of syringealdezine and 2 ml of a 10% by weight solution of 1-[2'-(3'-carboxyethyl thiazolidine)]-2-methyl-2[3''-(2''-thio-3-ethyl thiazolidine)-4''-one]-dimethine merocyanine in methanol and coated at 1.02 x 10$^{-4}$m in wet thickness and dried at 180°F (82°C). A second trip coating was applied over the dried first trip coating comprising 140 grams of the master batch composition, 280 g toluene and 280 g acetone. Fifty (50) grams of this composition was mixed with 0.2 g of phthalazinone and coated at 1.02 x 10$^{-4}$m in wet thickness and dried at 180°F (82°C). The film was exposed through a neutral step wedge and developed for eight seconds at 270°F (130°C). Dmax was 1.70 and Dmin was 0.03.

As noted in this text, the substrates of the present invention have improved transparency to radiation. To attain the preferred minimum transparency levels of 93, 95 and 97% transmissivity to radiation between 420 and 750 nm, it is generally preferred, if not necessary to coat both sides of the substrate. Coating of only the backside or topside of the substrate will not suffice. U.S. Patent Application Serial No. 823,384, filed January 28, 1986 shows coating of the backside of the substrate and coating of the surface of the photosensitive (e.g., photographic) media with sol gel coatings. The total transmissivity of the system is a maximum of 95%, but the transmission capability of the substrate itself is much lower, having been coated on only one surface. This can be seen in Table 6 of Example 4 wherein one-side coated substrates displayed transmission levels of at most 92.2% between 400 and 900 nm, with an average transmission of about 91% between 400 and 700 nm. Table 4 in Example 2 shows better one-side coatings on substrates which are still below 93% transmission between 420 and 750 nm, averaging about 92.2% transmission.

Example 16

To 400 g of Nalco™ 2326 silica dispersion (average particle size 5 nm) were added 2600 g of distilled water and 180 mL of a 4 weight percent solution of surfactant sodium salt of alkylaryl polyether sulfonate (Triton™ X-200, Rohm and Haas Co.). This dispersion was coated on factory produced rolls of LOC™ and LOD™ graphic arts films, 3M Company. A 23 cm (9 inch) wide coating was applied with the web moving at 9.6 m (32 feet) per minute using the extrusion coating bar pumping the dispersion at 10 mL per minute. The drying was carried out in four different zones to provide a dried coating weight of 0.09 $g/m^2$. The drying temperatures in the order encountered by the web were: 27, 49, 49, and 27°C (80, 120, 120 and 80°F). Both the emulsion and the antihalation surfaces were coated and dried under these conditions.

These films were imaged, processed and the transmissions were measured on a Diano™ Spectrophotomer, model Matchscan II (Milton Roy Co., Rochester, NY). Table 15 below shows transmission values at various wavelengths.

## Table 15

Light Transmission at Various Wavelengths

| Wave Length (nm) | LOC[1] % | LOD[2] % | LOC[3] Comparative % |
|---|---|---|---|
| 380 | 87.3 | 88.1 | 79.5 |
| 400 | 91.0 | 91.6 | 82.2 |
| 430 | 92.8 | 94.4 | 84.4 |
| 460 | 93.2 | 95.3 | 84.9 |
| 500 | 94.4 | 95.8 | 85.9 |
| 530 | 94.5 | 95.7 | 86.3 |
| 560 | 94.6 | 95.9 | 86.6 |
| 600 | 94.3 | 95.9 | 86.8 |
| 650 | 93.8 | 95.3 | 87.3 |
| 700 | 93.8 | 95.3 | 87.5 |

(1) Lights On Contact film (3M) contact film coated on both surfaces as described in this example.

(2) Lights On Duplicating film (3M) contact film coated on both surfaces as described in this example.

(3) LOC uncoated control.

### Example 17

Coatings of various compositions as shown in TABLE II below were prepared containing Nalco 2326 (ammonia stabilized colloidal silica; 14.5% colloidal silica as $SiO_2$, average particle size 5 nm, available from Nalco Chemical Company) and surfactant Triton X-200. Some of the coatings contained sufficient poly(ethyl acrylate) added as a 20 weight percent latex to provide the coating weight shown in Table 16A, coating 7-3 and 7-6, below. Poly(ethyl acrylate) was added to provide abrasion resistance. A typical coating solution was

| Nalco 2326 | -- 70 grams |
| 4% sodium salt of alkylaryl polyether sulfonate | |
| (Triton X-200) | -- 60 grams |
| deionized water | -- 872 grams |

The various solutions were coated onto the surface(s) of a photographic negative acting graphic arts DRC[TM] contact film (3M), which had a typical construction of emulsion layer and topcoat layer on one side of a primed and subbed 100 micrometer (4 mil) polyester substrate and an antihalation layer and topcoat layer on the opposite side of the primed and subbed 100 micrometer (4 mil) transparent polyester substrate.

The solutions of the present invention were applied to either one or both surfaces of six samples DRC film using an extrusion bar coating. One uncoated comparison film was included. The flow rate of the colloidal silica solution was 20 mL/min. It flowed down the coating bar and onto a moving web of the DRC which was 22 cm (8.5 inches) wide and traveling at a speed of 9.6 m (32 feet) per min. The concentration of components in the solutions was varied to achieve the coating weights. The applied coating was dried at about 18°C (65°F) so as not to remelt the gelatin in the photographic film. The resulting coatings were porous and continuous and observed to have good antireflection and transmission properties.

In order to evaluate the transmission properties of the various coatings the coated and dried films were cut into 20x24 cm (8x10 inch) sheets and then processed without prior exposure to radiation in a typical rapid access processor (Pako 32 MQ) containing 3M-RDC developer at 38°C (100°F) and fix at 43°C (110°F) and a drying section at 43°C (110°F).

The clear sheets of film were then analyzed for light transmission using a Diano spectrophotometer, Model Matchscan II (Miton Roy Co., Rochester, NY).

The formulations and light transmission data at various wavelengths is shown in Tables 16A and 16B below.

Table 16A

| | Effect of Silica Coating(s) on Optical Transmission Coating Trials | | | | | | |
|---|---|---|---|---|---|---|---|
| Coating | 7-0 | 7-1 | 7-2 | 7-3 | 7-4 | 7-5 | 7-6 |
| Colloidal silica on surface of antihalation side (g/sq m)* | – | 0.095 | 0.095 | 0.095 | 0.19 | 0.19 | 0.19 |
| Colloidal silica on surface of emulsion side (g/sq m)* | – | – | 0.095 | 0.095 | – | 0.19 | 0.19 |
| Polyethylacrylate coverage on emulsion side (g/sq m)** | – | – | – | 0.095 | – | – | 0.095 |

Table 16B

| | Transmission | | | | | | |
|---|---|---|---|---|---|---|---|
| Wavelength (nm) | 7-0 | 7-1 | 7-2 | 7-3 | 7-4 | 7-5 | 7-6 |
| 380 | 80.9 | 83.7 | 87.1 | 84.7 | 81.4 | 83.0 | 83.5 |
| 400 | 83.6 | 86.6 | 90.0 | 87.5 | 84.4 | 85.8 | 86.3 |
| 430 | 85.6 | 88.6 | 92.0 | 89.6 | 86.9 | 88.3 | 88.4 |
| 460 | 86.8 | 89.9 | 93.0 | 90.9 | 88.7 | 90.3 | 89.9 |
| 500 | 88.0 | 90.9 | 93.8 | 92.0 | 90.3 | 92.5 | 91.5 |
| 530 | 88.4 | 91.0 | 93.8 | 92.3 | 90.9 | 93.5 | 91.8 |
| 560 | 88.6 | 91.6 | 94.0 | 92.9 | 91.7 | 94.3 | 92.7 |
| 600 | 88.3 | 91.1 | 93.6 | 92.6 | 91.8 | 95.1 | 92.9 |
| 650 | 87.9 | 90.7 | 92.7 | 91.7 | 92.3 | 95.6 | 93.9 |
| 700 | 88.8 | 90.2 | 92.2 | 92.3 | 92.2 | 96.4 | 94.4 |

\*   applied as solution and oven dried
\*\* when present, is in the solution applied to the emulsion side

The data of Table 16B show improved transmission for silver halide photographic element having coatings of the invention on one or both surfaces, the greatest improvements being obtained when both surfaces were coated.

Example 13 - dot-for-dot exposure.

Exposure device - OLEX™ 1000 watt quartz light (Olec Corp., Costa Mesa, CA)

Processing device - RA 24 processor (3M) with RDC rapid access developer (3M, St. Paul, MN) at 100°F for 20 seconds.

LOE™ (3M) negative acting contact film was exposed in E-E (emulsion to emulsion) and E-B (emulsion to base) contact modes with an original halftone. These samples were compared to the same material which had a colloidal silica coating of this invention of 0.143 g/sq m on both surfaces (no poly(ethyl acrylate) was added). The colloidal silica coating was prepared and applied as in Example 17.

The results are shown in Tables 17A and B below.

## Table 17A

| E-E exposure | | Original dot %[1] | | | | | | | | | | |
|---|---|---|---|---|---|---|---|---|---|---|---|---|
| | | 5 | 9 | 20 | 28 | 39 | 50 | 59 | 70 | 80 | 91 | 95 |
| Film | Exposure | Δ Dot(2) | | | | | | | | | | |
| LOE | 4.5 units | 0 | 0 | 1 | 1 | 1 | 2 | 2 | 1 | 0 | 0 | 0 |
| LOE with 0.143 g/sq m colloidal silica both surfaces | 4.5 units | 0 | 0 | 0 | 0 | 0 | 0 | 0 | 0 | 0 | -1 | -1 |

## Table 17B

| E-B Exposure | | Original dot % (1) | | | | | | | | | | |
|---|---|---|---|---|---|---|---|---|---|---|---|---|
| | | 5 | 9 | 20 | 28 | 39 | 50 | 59 | 70 | 80 | 91 | 95 |
| Film | Exposure | Δ Dot (2) | | | | | | | | | | |
| LOE | 19 units | 1 | 1 | 1 | 0 | 0 | 0 | 1 | 2 | 2 | 2 | 1 |
| LOE with 0.143 g/sq m colloidal silica on both surfaces | 19 units | 0 | 0 | 0 | 1 | 1 | 0 | 1 | 1 | 1 | 1 | 1 |

(1)   percent of surface area covered by dots

(2)   Δ Dot = actual dot % - (100% - original dot %)

0 means no change, the best possible image result; positive or negative number mean larger or small image dots, respectively; the more negative the number, the smaller the dot produced; the more

17A - The data of Table 17A show improved dot for dot when the film was coated with silica on both surfaces.

17B - The data of Table 17B improved dot-for-dot for the film with colloidal silica coating.


## Example 19

Samples of LOE $^{TM}$ (Lights On Etching contact film, 3M) with and without a colloidal silica coating (coating prepared as in Example 16 but had a dried weight of 0.071 $g/m^2$ of colloidal silica on each surface) were dry etched E-E to see what effect the increased transparency film would have.

The data are shown in Table 18 below:

### Table 18

E-E exposure

| Film | Exposure | Original dot % | | | | | | | | | | | |
|---|---|---|---|---|---|---|---|---|---|---|---|---|---|
| | | 5 | 9 | 20 | 28 | 39 | 50 | 59 | 70 | 80 | 91 | 95 |
| | | Δ Dot (1) | | | | | | | | | | |
| LOE | 3.5 units | 1 | 0 | | | 1 | | 1 | | | | |
| | 14.0 units | 1 | 2 | | | 5 | | 4 | | | | |
| | 35 units | 4 | 8 | | | 11 | | 9 | | | | |
| LOE with 0.071 g/sq m colloidal silica on each surface | 3.5 units | 0 | 0 | | | 1 | | 1 | | | | |
| | 14.0 units | 2 | 4 | | | 7 | | 4 | | | | |
| | 35.0 units | 4 | 9 | | | 14 | | 11 | | | | |

The data of Table 18 show improved dot change with overexposure (dry etching) which is helpful to those skilled in the art of color correction and image modification.

(1)   See footnote (2) in Example 18.

Example 20

Coated samples of the invention (LOC and LOD) described in Example 16 were also measured for Dmin on a MacBeth™ densitometer (Model No. TD904, Kollmorgan Corp., Newburgh, NY) in several overlay configurations.

The results are shown below in Table 19.

### Table 19
#### Dmin Values

| Film | 1 sheet | 2 sheets | 3 sheets | 4 sheets |
|---|---|---|---|---|
| LOC control | 0.03 | 0.07 | 0.12 | 0.15 |
| LOC 38-6 | 0.01 | 0.02 | 0.04 | 0.07 |
| LOD control | 0.03 | 0.07 | 0.11 | 0.15 |
| LOD 38-6 | 0.01 | 0.02 | 0.04 | 0.06 |

The data of Table 19 show lower Dmin values for the colloidal silica coated samples. This is a result of their improved transmission and reduced light reflectance. This has benefits in viewing overlayed images (which look much clearer) and in exposing through these overlays as demonstrated in Example 21, below.

Example 21 - Overlay Exposures

Coated samples described in Example 16 were used in some overlay exposure tests. The arrangement for the exposure was to have the unexposed film emulsion up, on the bottom of the stack. In contact with this (E-E) was a halftone imaged dot target and above this were 3 clear overlays comprised of unexposed, processed sheets of the same film. LOC/LOD control refers to noncoated or treated material whereas LOC coated samples refer to LOC coated with 0.095 $g/m^2$ colloidal silica (dried coating weight) on both surfaces and LOD coated samples refers to LOD coated with 0.095 $g/m^2$ colloidal silica (dried coating weight) on both surfaces. Standard material was compared with colloidal

silica treated material. The data were as shown in Tables 20A and 20B below.

### Table 20A

| Film(2) | Exposure | Original dot % | | | | |
|---|---|---|---|---|---|---|
| | | 9 | 39 | 50 | 70 | 91 |
| | | Δ Dot(1) | | | | |
| LOC control | 5.6 units | 2 | 3 | 2 | 3 | 2 |
| LOC (coated) | 6.6 units | 1 | 0 | −1 | 0 | 1 |

### Table 20B

| Film | Exposure | Original dot % | | | | |
|---|---|---|---|---|---|---|
| | | 9 | 39 | 50 | 70 | 91 |
| | | actual dot % − original dot %(3) | | | | |
| LOD control | 13.2 units | 0 | 2 | 2 | 2 | 1 |
| LOD (coated) | 11.1 units | 0 | 0 | 0 | 0 | 0 |

(1) see footnote (2) in Example 18
(2) 4 overlays in each case (3 clear + half tone)
(3) dot calculation differs from Examples 18 and 19 because a positive system is used in Table 20B

The data of Tables 20A and 20B show improved dot for dot images result when colloidal silica coatings of this invention are used in multiple overlay contact applications.

CLAIMS

1. A photosensitive article comprising at least one photosensitive layer on a substrate selected from the group consisting of

a) resist or non-resist photosensitive layer(s) on an opaque substrate

b) resist layer(s) on a transparent substrate, and

c) non-resist photosensitive layer(s) on a transparent substrate wherein

articles of a) have an exterior surface modification which increases transmission of white light into said photosensitive layer by at least 2 percent,

articles of b) have a surface modification on at least one of the substrate surfaces and/or on the resist layer which increases transmission of white light through said surface by at least 2 percent, and

articles of c) wherein at least one exterior surface of said article has a surface modification which increases transmission of white light through said surface by at least 2 percent.

2. A radiation-sensitive imageable element comprising a substrate having on at least one of its exterior surfaces a coating of inorganic oxide particles having an average primary particle size of less than 20 nm and a dried coating weight in the range of 0.05 to 1.0 $g/m^2$.

3. The element according to Claim 2 wherein said inorganic oxide coating is a continuous, gelled network which provides said element with an average increase in transmission to radiation as compared to an uncoated element of at least one percent over wavelengths of 350 to 1000 nm.

4.  The element according to Claim 2 wherein said inorganic oxide particles are silica, alumina, tin oxide, antimony oxide, zirconium oxide, or alumina-coated silica.

5.  The element of Claim 2 wherein said inorganic oxide particles have a primary average particle size in the range of 2 to 10 nm.

6.  The element of Claim 1 wherein said coating is about 70 to 250 nm thick.

7.  The element of Claim 2 wherein said coating has an open porosity of between about 25 and 70 percent.

8.  The element of Claim 2 wherein said dried coating weight is in the range of 0.05 to 0.5 $g/m^2$.

9.  The element of Claim 8 wherein the transmission therethrough of normal incident light in the wavelength range of 350 to 1000 nm is increased over the transmission through an uncoated element of the same composition.

10. The element of Claim 9 wherein said transmission is increased at least 1 percent.

11. The element of Claim 2 wherein said coating has an index of refraction of between about 1.15 and 1.40.

12. The element according to Claim 1 wherein the element has a photosensitive media thereon which comprises silver halide.

13. A process for providing a photographic imaged article comprising the steps:

a) providing silver halide radiation-sensitive imageable element having on at least one of its exterior surfaces a coating of inorganic oxide particles having an average primary particle size of less than 20 nm and a dried coating weight in the range of 0.05 to 1.0 g/m$^2$,

b) imagewise exposing said element to radiation in the range of 350 to 1000 nm, and

c) developing the resulting radiation-exposed element to provide a developed image.

14. A process for providing a high light transmission silver halide radiation-sensitive imageable article comprising the steps:

a) providing a silver halide radiation-sensitive imageable element,

b) coating at least one exterior surface of said element with a solution of colloidal inorganic oxide particles having a dried coating weight in the range of 0.05 to 1.0g/m$^2$, and

c) drying said coating at a temperature less than that which degrades said article, thereby providing a substantially continuous coating of a gelled network of inorganic oxide particles which is substantially uniform in thickness and which provides said substrate with an average increase in transmission of radiation of at least two percent over wavelengths of 350 to 1000 nm.

15. An article comprising a photosensitive media on a transparent substrate, said transparent substrate being characterised by the fact that it is at least 93% transmissive to white light.

16. The article of Claim 15 wherein said substrate is at least 95% transmissive to white light.

17. The article of Claim 15 wherein said substrate is at least 98% transmissive to white light.

18. An article comprising a photosensitive media on a transparent substrate, said substrate being characterised by the fact that at least one surface thereof has a surface morphology in which the frequency and dimensions of its non-planar features are within the range of 25 to 250 nm.

19. The article of Claims 15 to 18 characterised in that the photosensitive media comprising a photosolublizable phototackifiable layer or photohardenable layer, the photohardenable layer optionally being associated with a colorant which is present either within said photohardenable layer or with a layer adjacent said photohardenable layer.

20. The article as claimed in any one of Claims 15 to 19 characterised in that said substrate.has at least one surface consisting essentially of a layer of particles, said layer having a thickness of between 25 and 250 nm.

21. The article as claimed in any one of Claims 15 to 20 characterised in that said substrate has on at least one surface a layer which comprises a layer of particles having average diameters between 0.5 and 50 nm.

22. The article as claimed in Claim 21 characterised in that said layer of particles comprises a continuous gelled network of inorganic particles having average diameters beween 0.5 and 50 nm.

23. An imaged article obtained by image-wise exposure and processing an article as claimed in any one of Claims 1 to 12 and 15 to 22.